# EUROPÄISCHE PATENTSCHRIFT

(11) **EP 2 136 418 B1**
(45) Veröffentlichungstag und Bekanntmachung des Hinweises auf die Patenterteilung: **13.04.2016**
(21) Anmeldenummer: 09163109.3
(22) Anmeldetag: 18.06.2009
(51) Int. Cl.: H01L 41/083, H01L 41/193, H01L 41/27

(54) **Faltaktor oder Faltsensor sowie Herstellungsverfahren für einen Faltaktor oder Faltsensor**
Fold actuator or fold sensor and production method for same
Actionneur de pliage ou capteur de pliage et procédé de fabrication pour un actionneur de pliage ou un capteur de pliage

(30) Priorität: 18.06.2008 DE 102008002492
(43) Veröffentlichungstag der Anmeldung: 23.12.2009
(73) Patentinhaber: Robert Bosch GmbH, 70442 Stuttgart (DE)
(72) Erfinder: Hagemann, Benjamin, 70839 Gerlingen (DE); Schmidt, Ralf, 70839 Gerlingen (DE)

(56) Entgegenhaltungen:
- WO-A1-2007/029275
- JP-A- 2006 066 901
- US-B1- 6 208 065
- FEDERICO CARPI ET AL: "Folded dielectric elastomer actuators", SMART MATERIALS AND STRUCTURES, IOP PUBLISHING LTD., BRISTOL, GB, Bd. 16, Nr. 2, 1. April 2007 (2007-04-01), Seiten S300-S305, XP020120446, ISSN: 0964-1726, DOI: 10.1088/0964-1726/16/2/S15

## Beschreibung

### Stand der Technik

Die Erfindung betrifft einen Faltaktor/Faltsensor gemäß dem Oberbegriff des Anspruchs 1 sowie ein Herstellungsverfahren gemäß dem Oberbegriff des Anspruch 15.

Es sind Vielschichtaktoren bekannt, die aus einem einzigen Elektrodenstreifen gefaltet sind, wobei der Elektrodenstreifen aus einer mittleren Schicht aus einem dielektrischen, deformierbaren Material besteht, auf das beidseitig Elektrodenschichten aufgebracht sind. Durch Hin- und Herfalten des Elektrodenstreifens um jeweils 180° ergibt sich eine Faltaktorstruktur mit einer Vielzahl von nebeneinander angeordneten, sich parallel zueinander erstreckenden Elektrodenabschnitten, zwischen denen dielektrisches, deformierbares Material angeordnet ist. Bei Anlegen einer elektrischen Spannung zieht sich der Vielschichtaktor in Stapelrichtung aufgrund der resultierenden elektrostatischen Anziehung der Elektrodenabschnitte zusammen. Typische Elektrodenstreifendicken liegen derzeit im Bereich von etwa 0,5mm. Zum Erzielen einer Aktorbewegung werden elektrische Feldstärken von bis zu etwa 200 V/µm benötigt. Nachteilig bei dem bekannten Faltaktor ist die mangelnde Stabilität, insbesondere bei einer Belastung auf Zug.

Weiterhin ist es bekannt, mehrere aus jeweils einem einzigen Elektrodenstreifen gefaltete Vielschichtaktoren nebeneinander anzuordnen und zu einem gemeinsamen Aktor zusammenzufassen. Dabei kann, wenn nicht sämtliche Aktoren gleichzeitig angesteuert werden, eine Verkippung des gesamten Aktors erreicht werden.

Die JP 2006-066901 A offenbart ein piezo-elektrisches Element, welches in seiner Dickenrichtung gefaltet ist.

Die WO 2007/029275 A1 offenbart einen Aktuator mit einem elektroaktiven Polymer, welcher eine Faltkonfiguration aufweist.

### Offenbarung der Erfindung

### Technische Aufgabe

Der Erfindung liegt die Aufgabe zugrunde, ein alternatives Faltaktorprinzip oder Faltsensorprinzip vorzuschlagen, insbesondere sollen mit diesem Faltaktorprinzip oder Faltsensorprinzip besonders robuste Faltaktoren bzw. Faltsensoren herstellbar sein. Ferner besteht die Aufgabe darin, ein entsprechend optimiertes Verfahren zum Herstellen eines derartigen Faltaktors oder Faltsensors vorzuschlagen.

### Technische Lösung

Diese Aufgabe wird hinsichtlich des Faltaktors und des Faltsensors mit den Merkmalen des Anspruchs 1 und hinsichtlich des Herstellungsverfahrens mit den Merkmalen des Anspruchs 15 gelöst. Vorteilhafte Weiterbildungen der Erfindung sind in den Unteransprüchen angegeben. In den Rahmen der Erfindung fallen sämtliche Kombinationen aus zumindest zwei von in der Beschreibung, den Ansprüchen und/oder den Figuren offenbarten Merkmalen. Zur Vermeidung von Wiederholungen sollen vorrichtungsgemäß offenbarte Merkmale auch als verfahrensgemäß offenbart gelten und beanspruchbar sein. Ebenso sollen verfahrensgemäß offenbarte Merkmale als vorrichtungsgemäß offenbart gelten und beanspruchbar sein.

Der Erfindung liegt der Gedanke zugrunde, einen quasi monolithischen und damit robusten Aufbau eines Faltaktors bzw.

Faltsensors dadurch zu realisieren, dass der Faltaktor bzw. Faltsensor nicht, wie im Stand der Technik, aus einem einzigen Elektrodenstreifen gefaltet ist oder aus mehreren, jeweils aus einem einzigen Elektrodenstreifen gefalteten, Faltaktoren bzw. Faltsensoren zusammengesetzt ist, sondern mindestens zwei Elektrodenstreifen ineinander gefaltet werden. Durch das Ineinanderfalten von mindestens zwei Elektrodenstreifen wird ein besonders robuster, d. h. ineinander verschachtelter, Faltaktoraufbau bzw. Faltsensoraufbau realisiert, der als Grundkonzept einer Vielzahl von unterschiedlichen Falttechniken zugrunde gelegt werden kann. Wesentlich ist lediglich, dass mindestens zwei Elektrodenstreifen, beispielsweise wechselseitig, ineinander gefaltet werden. Erfindungsgemäß weist mindestens einer der Elektrodenstreifen mindestens eine Elektrodenschicht und mindestens eine deformierbare Dielektrikumsschicht auf. Zur Ansteuerung eines Faltaktors muss eine Spannungsquelle vorgesehen werden, mit der an die Elektrodenabschnitte des Faltaktors eine elektrische Spannung anlegbar ist. Ein Faltsensor kann beispielsweise dadurch ausgewertet werden, dass die Kapazität und/oder der Widerstand von Elektrodenabschnitten gemessen wird.

Im Folgenden werden vorteilhafte Ausbildungsformen der Erfindung zur erleichterten Lesbarkeit der Anmeldung am Beispiel von Faltaktoren erläutert, wobei sämtliche Ausführungen analog auch für Faltsensoren gelten.

Besonders bevorzugt ist eine Ausführungsform, bei der mindestens zwei ineinander gefaltete Elektrodenstreifen, bevorzugt sämtliche ineinander gefaltete Elektrodenstreifen jeweils mindestens eine Elektrodenschicht und mindestens eine, vorzugsweise fest mit der Elektrodenschicht verbundene, deformierbare Dielektrikumsschicht umfassen. Ganz besonders bevorzugt ist es dabei, wenn die mindestens eine Elektrodenschicht wie die Dielektrikumsschicht, vorzugsweise elastisch, deformierbar ausgebildet ist. Dies kann beispielsweise dadurch erreicht werden, dass in ein deformierbares Material elektrisch leitende Partikel, beispielsweise Kohlenstoffpartikel, eingearbeitet werden. Besonders bevorzugt ist es, wenn es sich bei dem die deformierbare Dielektrikumsschicht bildenden Material (bis auf die elektrisch leitenden Partikel) um ein elektroaktives Material, vorzugsweise ein Polymer, insbesondere Silikon oder Acrylat, handelt. Besonders bevorzugt ist eine Ausführungsform, bei der die Dielektrikumsschicht elastisch verformbar ist. Ganz besonders bevorzugt handelt es sich bei dem die Dielektrikumsschicht bildenden, deformierbaren Material um ein Elastomer, beispielsweise aus der Gruppe der Silikone und/oder der Acrylate. Mit Vorteil umfasst oder besteht das Elastomer aus Silikon und/oder Fluorsilikon und/oder Polyurethan und/oder Polybutadien und/oder Polyacryl und/oder Polytetrafluorethylen und/oder P(VDF-TrFE)-Copolymer und/oder Isopren und/oder Acrylat. Auch die Elektrodenschicht kann aus einem derartigen Material ausgebildet werden, wobei in diesem Fall, wie erläutert, elektrisch leitende Partikel zur Herstellung der Elektrodenfunktion zuzumischen sind. Alternativ kann die Elektrodenschicht vollständig aus elektrisch leitenden Partikeln, wie Kohlenstoffpartikel, Carbonanotubes, etc. gebildet sein. Weiterhin ist es möglich, die Elektrodenschicht aus elektrisch leitendem Polymer auszubilden.

Ganz besonders bevorzugt ist eine Ausführungsform des Faltaktors, bei der mindestens zwei der Elektrodenstreifen vor dem Ineinanderfalten, d. h. in einem abgewickelten (entfalteten) Zustand, rechtwinklig zueinander angeordnet sind. Dabei ist eine Ausführungsform bevorzugt, bei der die Elektrodenstreifen vor dem Ineinanderfalten voneinander separate Bauelemente des Faltaktors sind, die erst durch Ineinanderfalten miteinander verbunden (verschachtelt) werden. Alternativ ist eine Ausführungsform realisierbar, bei der mindestens zwei der Elektrodenstreifen, beispielsweise auch sämtliche Elektrodenstreifen, einstückig ausgebildet sind bzw. einenends miteinander verbunden sind, wobei hier wesentlich ist, dass mindestens zwei der Elektrodenstreifen winklig, vorzugsweise rechtwinklig, zueinander angeordnet sind. Anders ausgedrückt werden dabei die Elektrodenstreifen von Streifenabschnitten eines gemeinsamen Bauteils gebildet.

Neben einer Ausführungsform mit ausschließlich zwei ineinander gefalteten, vor dem Falten vorzugsweise rechtwinklig zueinander angeordneten, Elektrodenstreifen ist beispielsweise eine Ausführungsform mit vier Elektrodenstreifen realisierbar, wobei sich die vier Elektrodenstreifen vor dem Falten, also im abgewickelten (entfalteten) Zustand, in vier unterschiedliche Richtungen erstrecken, vorzugsweise, zumindest näherungsweise, kreuzförmig angeordnet sind. Dabei kann das Ineinanderfalten der einzelnen Elektrodenstreifen auf unterschiedlichste Weise vollzogen werden. So ist es beispielsweise, wie später noch erläutert werden wird, möglich, die Elektrodenstreifen immer der Reihe nach in Umfangsrichtung nach innen umzufalten, oder alternativ immer zwei einander gegenüberliegende Elektrodenstreifen gleichzeitig oder nacheinander. Auch ist es möglich, zumindest teilweise, eine Art geflochtenen Aufbau zu realisieren, bei dem ein Elektrodenstreifen unter einem zuvor umgelegten, d. h. zuvor gefalteten, Elektrodenstreifen hindurchgeführt ist.

Insgesamt wird durch das Ineinanderfalten von vier Elektrodenstreifen bevorzugt ein Faltaktor erhalten, der von seinem prinzipiellen Aufbau her vier fest miteinander verbundenen Stapelaktoren entspricht, die bei entsprechender Ausbildung der Elektrodenschichten jeweils einzeln angesteuert werden können. Hierdurch kann in vorteilhafter Weise sowohl eine Kontraktion des gesamten Stapels durch gleichzeitige Ansteuerung aller vier (Teil-)Aktoren als auch eine bidirektionale Biegung durch gleichzeitige Ansteuerung zweier benachbarter (Teil-)Aktoren als auch eine schräge Biegung durch Ansteuerung nur eines einzelnen (Teil-)Aktors realisiert werden.

Grundsätzlich wird bereits durch das Ineinanderfalten von mindestens zwei, insbesondere identisch ausgebildeten, Elektrodenstreifen eine deutlich verbesserte Verbindung der Aktorschichten untereinander erreicht, mit der Folge einer deutlich verbesserten Aktorstabilität. Bei Bedarf kann zusätzlich ein abschließender Tauchprozess realisiert werden, um den gefalteten Aktor vollumfänglich, insbesondere mit einem Polymermaterial (Polymerhülle), zu beschichten, wodurch die Stabilität des Faltaktors weiter erhöht werden kann.

Anstelle der beschriebenen 1 * 1 Matrix, hergestellt aus zwei ineinander gefalteten Elektrodenstreifen, oder einer 2 * 2 Matrix, hergestellt aus vier, im entfalteten Zustand im Wesentlichen kreuzförmig angeordneten, Elektrodenstreifen, ist durch das Ineinanderfalten von mehreren Elektrodenstreifen grundsätzlich jede n * m Matrix realisierbar, wobei die Variablen n und m jeweils mindestens 1 betragen und entweder gleich oder unterschiedlich groß sind. Bevorzugt wird eine derartige n * m Matrix aus n + m Elektrodenstreifen hergestellt, von denen zumindest zwei Elektrodenstreifen (vor dem Falten) winklig, insbesondere rechtwinklig, zueinander anzuordnen sind. Eine nahezu beliebige n * m Matrix kann beispielsweise auch nur mit zwei Elektrodenstreifen realisiert werden, wobei mindestens ein Elektrodenstreifen mehrere unabhängige Elektroden aufweist. Es werden also durch das Ineinanderfalten von mehreren Elektrodenstreifen maximal n * m (Teil-)Aktoren erhalten, die auf unterschiedlichste Weise angesteuert werden können, wobei je nach Größe der Matrix und je nach Ausgestaltung der Elektrodenstreifen, insbesondere der Elektrodenschichten der Elektrodenstreifen einzelne (Teil-)Aktoren separat oder in Gruppen ansteuerbar sind.

Wie zuvor bereits angedeutet, können unterschiedliche Falttechniken zum Herstellen des Faltaktors aus mindestens zwei ineinander zu faltenden Elektrodenstreifen realisiert werden. Gemäß einer ersten Alternative ist es möglich, die Elektrodenstreifen durch einfaches Übereinander- bzw. Nebeneinanderfalten ineinander zu falten. Dabei ist es als Unterfall denkbar, die Elektrodenstreifen der Reihe nach, in Umfangsrichtung betrachtet, nach innen zu falten. Alternativ ist es möglich, insbesondere bei einer Anordnung mit in vier rechtwinklig zueinander angeordneten Richtungen orientierten Elektrodenstreifen, jeweils die auf einander gegenüberliegenden Seiten angeordneten Elektrodenstreifenabschnitte gleichzeitig oder nacheinander nach innen umzufalten.

Besonders bevorzugt ist eine Falttechnik, bei der zumindest zwei Elektrodenstreifen miteinander verflochten bzw. verwoben werden. Dies kann dadurch realisiert werden, dass ein Elektrodenstreifen unter einem bereits gefalteten Elektrodenstreifen hindurch geführt wird.

Auch im Hinblick auf den Aufbau der Elektrodenstreifen gibt es unterschiedliche Möglichkeiten. So ist es besonders bevorzugt, wenn sämtliche Elektrodenschichten eines Elektrodenstreifens, zumindest an den Längsseiten des Elektrodenstreifens nicht an die Außenseite ragen, um Fehlkontaktierungen zu vermeiden. Die Elektrodenstreifen können beispielsweise mittels eines Sprühverfahrens hergestellt werden. Dabei wird beispielsweise mit einer ersten deformierbaren Dielektrikumsschicht, insbesondere einer Silikonschicht, begonnen, die durch einen Sprühprozess beispielsweise auf einen Träger aufgetragen wird. Auf diese Schicht wird dann, beispielsweise vollflächig, vorzugsweise unter Freihaltung von Randbereichen, eine Elektrodenschicht aufgebracht und in einem weiteren Prozessschritt wird diese Elektrodenschicht mit einer weiteren, deformierbaren Dielektrikumsschicht überdeckt. Gegebenenfalls können auf die zuletzt aufgebrachte deformierbare Dielektrikumsschicht weitere Schichten, vorzugsweise mindestens eine weitere Elektrodenschicht und darauf eine weitere Dielektrikumsschicht aufgebracht werden, besonders bevorzugt jeweils mittels eines Sprüh- oder Druckprozesses. Ein Elektrodenstreifen kann auch als selbstklebende Dielektrikumsfolie ausgeführt werden, auf die die Elektrode(n) aus leitfähigen Partikeln aufgestreut wird/werden und dann mit der nächstfolgenden Folie verklebt wird. Im Hinblick auf die Ausformung/ Strukturierung der Elektrodenschichten gibt es dabei unterschiedliche Möglichkeiten. Diese können unstrukturiert, d. h. vollflächig, oder strukturiert, beispielsweise zwei- oder mehrbahnig, ausgeführt sein. Auch ist es möglich, mehrere Elektroden in Richtung der Längserstreckung des Elektrodenstreifens nebeneinander in einer oder voneinander beabstandeten Elektrodenschichten zu realisieren, wie später noch im Detail erläutert werden wird.

Wie erwähnt, ist es möglich, einen besonders einfachen Faltaktoraufbau dadurch zu realisieren, dass zumindest eine Elektrodenschicht zumindest eines der Elektrodenstreifen, vorzugsweise sämtliche Elektrodenschichten des Elektrodenstreifens, noch bevorzugter sämtliche Elektrodenschichten sämtlicher Elektrodenstreifen des Faltaktors im Wesentlichen unstrukturiert, d. h. großflächig, aufgebracht sind, besonders bevorzugt mit Randabstand zu den Rändern des Elektrodenstreifens.

Alternativ ist es möglich, zumindest eine Elektrodenschicht zumindest eines der Elektrodenstreifen als mindestens zwei voneinander separate Elektroden zu strukturieren. Dabei können die Elektroden insbesondere als zwei parallele Bahnen ausgebildet sein, die voneinander beabstandet sind und separat ansteuerbar sind.

Gemäß einer weiteren Alternative ist es möglich, separate Elektroden in einer Elektrodenschicht nicht (nur) nebeneinander, sondern in Richtung der Längserstreckung des Elektrodenstreifens alternierend anzuordnen, beispielsweise dadurch, dass in Richtung der Längserstreckung beabstandete großflächige Elektrodenabschnitte vorgesehen sind, die durch geringflächige, insbesondere schmale, Verbindungsstränge miteinander verbunden sind.

Besonders bevorzugt ist es, in mindestens einem Elektrodenstreifen mindestens zwei voneinander separat ansteuerbare Elektroden zu realisieren, wobei die beiden Elektroden, wie zuvor erläutert, beispielsweise in einer gemeinsamen, strukturierten Elektrodenschicht realisiert werden können. Alternativ ist es möglich, mindestens zwei voneinander separate Elektroden in zwei nebeneinander/übereinander angeordneten Elektrodenschichten zu realisieren, wobei bevorzugt zwischen den beiden Elektrodenschichten mindestens eine deformierbare Dielektrikumsschicht als Isolator vorgesehen ist.

Wie eingangs erwähnt, ist es vorteilhaft, wenn zumindest einer der Elektrodenstreifen eine Dreischichtanordnung umfasst oder als solche ausgebildet ist, wobei die Dreischichtanordnung als Sandwichschichtaufbau realisiert ist, bei dem eine strukturierte oder unstrukturierte Elektrodenschicht zwischen zwei deformierbaren Dielektrikumsschichten aufgenommen ist. Alternativ ist es auch möglich, mehr als drei Schichten, besonders bevorzugt sieben Schichten, zu realisieren, wobei zwischen jeweils zwei Elektrodenschichten eine Dielektrikumsschicht aufgenommen ist und besonders bevorzugt die Schichtanordnung an den äußeren Flachseiten durch jeweils eine deformierbare Dielektrikumsschicht abgeschlossen ist.

Die Erfindung führt auch auf ein Verfahren zum Herstellen eines zuvor beschriebenen Faltaktors bzw. Faltsensors. Dabei ergeben sich die Verfahrensschritte für den Fachmann aus der vorhergehenden Schilderung des Faltaktoraufbaus. Wesentlich ist es, dass mindestens zwei, insbesondere rechtwinklig zueinander angeordnete, Elektrodenstreifen ineinander gefaltet werden.

### Kurze Beschreibung der Zeichnungen

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Fig. 1a:: einen noch nicht zu Ende gefalteten Faltaktor, der aus zwei rechtwinklig zueinander angeordneten Elektrodenstreifen hergestellt wird/ist,
- Fig. 1b:: eine Schnittansicht entlang der Schnittlinie A-A gemäß Fig. 1a, aus der ein möglicher Aufbau der Elektrodenstreifen des in Fig. 1a gezeigten Faltaktors ersichtlich ist,
- Fig. 2a:: ein alternatives Ausführungsbeispiel eines noch nicht zu Ende gefalteten Faltaktors, der aus zwei rechtwinklig zueinander angeordneten Elektrodenstreifen hergestellt wird/ist, wobei jeder Elektrodenstreifen eine strukturierte Elektrodenschicht aufweist, umfassend zwei parallel zueinander verlaufende, voneinander separat ansteuerbare Elektrodenbahnen,
- Fig. 3:: ein alternatives Ausführungsbeispiel eines noch nicht zu Ende gefalteten, aus vier kreuzartig angeordneten Elektrodenstreifen hergestellten Faltaktors, wobei zur Herstellung des Faltaktors jeweils zwei einander gegenüberliegende Elektrodenstreifen gleichzeitig oder unmittelbar nacheinander gefaltet werden,
- Fig. 4:: eine alternative Ausführungsform eines aus vier kreuzartig angeordneten Elektrodenstreifen gefalteten Faltaktors, bei dem die Elektrodenstreifen in Umfangsrichtung nacheinander nach innen gefaltet werden/sind,
- Fig. 5:: einen aus vier kreuzförmig angeordneten Elektrodenstreifen durch Verflechten hergestellten, noch nicht zu Ende gefalteten, Faltaktor,
- Fig. 6a:: ein weiteres alternatives Ausführungsbeispiel eines Faltaktors, der aus vier kreuzartig angeordneten Elektrodenstreifen gefaltet wird/ist, wobei jeder Elektrodenstreifen in Längsrichtung voneinander separate Elektrodenflächen aufweist, und wobei zusammenhängende Elektrodenflächen über Verbindungsstränge miteinander verbunden sind,
- Fig. 6b:: eine mögliche Schnittansicht entlang der Schnittlinie C-C gemäß Fig. 6a bei einer Ausführungsform mit dreischichtigem Elektrodenstreifen,
- Fig. 6c:: eine alternative Schnittansicht entlang der Schnittlinie C-C gemäß Fig. 6a, die einen fünfschichtigen Elektrodenstreifen zeigt, und
- Fig. 7:: die Darstellung eines nahezu zu Ende gefalteten Faltaktors, bei dem vier Elektrodenstreifen miteinander verwoben sind.

### Ausführungsformen der Erfindung

In den Figuren sind gleiche Bauteile und Bauteile mit der gleichen Funktion mit den gleichen Bezugszeichen gekennzeichnet.

Die im Folgenden beschriebenen Aufbauvarianten eines Faltaktors eignen sich auch zur Realisierung eines entsprechenden Faltsensors, beispielsweise als Bedienelement bei einer Seitenspiegelverstellung eines Kraftfahrzeugs. Dabei kann eine Detektion von komplexen Verkippungen durch Kapazitätsmessungen detektiert werden, wobei hierzu beispielsweise die Kapazität mindestens eines durch zwei Elektrodenschichten gebildeten Kondensators bestimmt wird. Insbesondere bei einem komplexen, später noch zu erläuternden, Matrix-Aufbau können komplexe Verkippungen detektiert werden - nicht nur in den Raumhauptrichtungen.

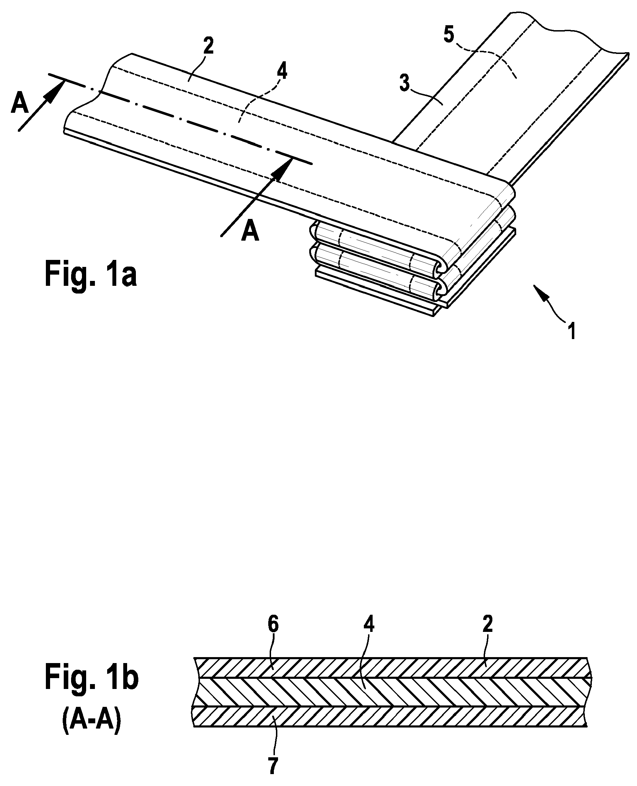

In Fig. 1a ist ein teilweise fertig gestellter Faltaktor 1 gezeigt. Dieser ist/wird gebildet durch abwechselndes Übereinanderfalten von zwei rechtwinklig zueinander angeordneten, rechteckig konturierten, Elektrodenstreifen 2, 3. Dabei werden die Elektrodenstreifen 2, 3 abwechselnd um rechtwinklig zueinander verlaufende Faltachsen übereinander gefaltet, wodurch sich ein geschichteter (gestapelter) Faltaktoraufbau ergibt. In Fig. 1a ist die Lage von Elektrodenschichten 4, 5 in den Elektrodenstreifen 2, 3 angedeutet. Dabei ist jede Elektrodenschicht 4, 5 zwischen zwei Schichten aus einem deformierbaren Dielektrikum aufgenommen. Der prinzipielle Aufbau der Elektrodenstreifen 2, 3 ergibt sich aus der Schnittdarstellung gemäß Fig. 1b, in der in einer Längsschnittdarstellung der Elektrodenstreifen 2 aus Fig. 1a gezeigt ist. Zu erkennen ist ein sandwichartiger Aufbau mit einer großflächigen, mittig angeordneten Elektrodenschicht 4, oberhalb und unterhalb derer sich deformierbare Dielektrikumsschichten 6, 7 befinden. Bevorzugt handelt es sich bei dem die Elektrodenschicht 4 sowie die deformierbaren Dielektrikumsschichten 6, 7 bildenden Material um Polymermaterial, wobei dieses innerhalb der Elektrodenschicht 4 bzw. zur Bildung der Elektrodenschicht 4 mit elektrisch leitenden Partikeln, beispielsweise Kohlenstoff, versetzt ist. Die übereinander gefalteten Elektrodenschichten bilden bei dem fertigen Faltaktor 1 die "gestapelten", über ein Dielektrikum voneinander getrennten Elektrodenabschnitte.

Wie sich aus Fig. 1a ergibt, sind die Elektrodenschichten 4 unstrukturiert als streifenförmige, rechteckig konturierte Bahnen ausgebildet, die mit allseitigem Randabstand innerhalb des jeweiligen, rechteckig konturierten, Elektrodenstreifens 2, 3 aufgenommen sind und sich in Längsrichtung des jeweiligen Elektrodenstreifens 2, 3 erstrecken. Die Elektrodenstreifen müssen nicht zwangsläufig rechteckig konturiert sein, sondern können im Prinzip jede, insbesondere langgestreckte, Geometrie aufweisen.

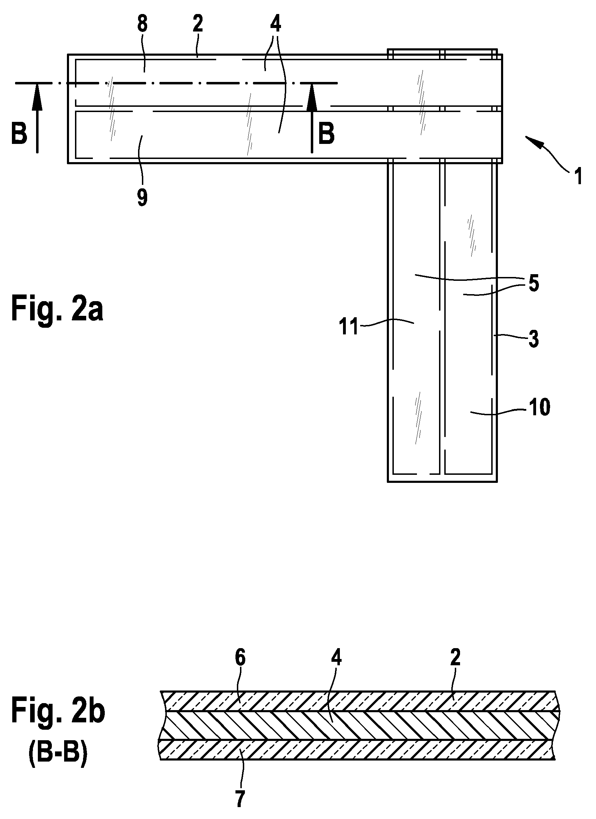

Der Aufbau des in Fig. 2a gezeigten, noch nicht fertig gestellten, Faltaktors 1 entspricht im Wesentlichen dem Aufbau des Faltaktors 1 gemäß Fig. 1a. Der wesentliche Unterschied besteht darin, dass die rechtwinklig zueinander angeordneten Elektrodenstreifen 2, 3 jeweils eine strukturierte Elektrodenschicht 4, 5 aufweisen, wobei die Elektrodenschichten 4, 5 jeweils derart strukturiert sind, dass sich jeweils zwei voneinander separate, hier streifenförmige und sich in Längsrichtung der Elektrodenstreifen 2, 3 erstreckende Elektroden 8, 9, 10, 11 ergeben. Die jeweils zwei Elektroden 8, 9 bzw. 10, 11 jedes Elektrodenstreifens 4, 5 sind quer zur Längserstreckung des jeweiligen Elektrodenstreifens 2, 3 voneinander beabstandet.

Wie die Längsschnittansicht gemäß Fig. 2b zeigt, ist die Elektrodenschicht 4 des Elektrodenstreifens 2 zwischen zwei deformierbaren Dielektrikumsschichten 6, 7 aufgenommen, die transparent ausgebildet sind, so dass die aus der strukturierten Elektrodenschicht 4 resultierenden Elektroden 8, 9 in der Darstellung gemäß Fig. 2a zu erkennen sind. Der in Fig. 2 gezeigte Aufbau des Elektrodenstreifens 2 gilt analog für den rechtwinklig zu diesem verlaufenden Elektrodenstreifen 3 gemäß Fig. 2a. Durch den vorgeschlagenen Aufbau wird ein Faltaktor 1 mit prinzipiell vier nebeneinander angeordneten Teil-Stapelaktoren erhalten.

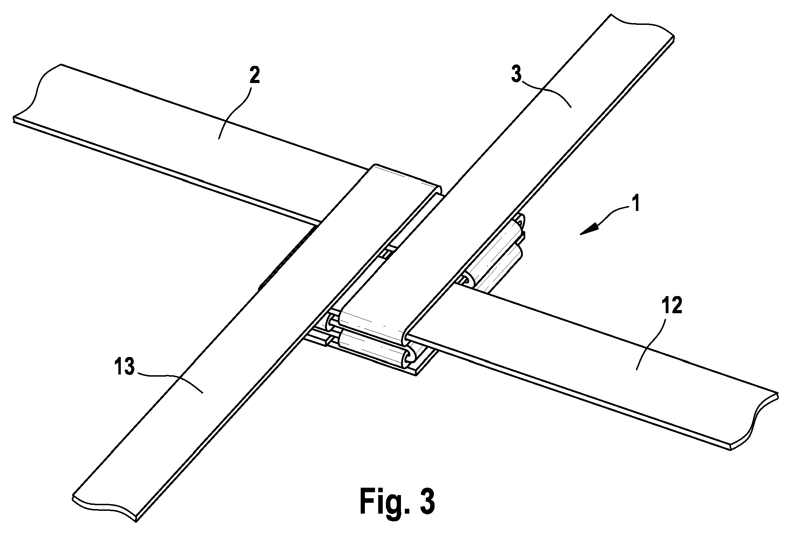

In Fig. 3 ist ein noch nicht zu Ende gefalteter Faltaktor 1 gezeigt, der aus insgesamt vier, im Wesentlichen kreuzförmig und in Querrichtung versetzt angeordneten Elektrodenstreifen 2, 3, 12, 13 gefaltet wird/ist. Dabei ist der Aufbau der Elektrodenstreifen 2, 3, 12, 13 nicht gezeigt, kann aber beispielsweise wie in den Fig. 1a bis 2b gezeigt und zuvor beschrieben realisiert werden. Die Elektrodenstreifen 2, 3, 12, 13 werden zum Herstellen bzw. Falten des Faltaktors 1 um rechtwinklig zueinander angeordnete Faltachsen gefaltet.

Zu erkennen ist, dass die Elektrodenstreifen 2, 12 einerseits und die Elektrodenstreifen 3, 13 andererseits jeweils in einander entgegengesetzte Richtungen weisen und quer zu ihrer Längserstreckung versetzt zueinander angeordnet sind, so dass die Elektrodenstreifen 3, 13 bzw. 2, 12 aneinander vorbei gefaltet werden können. Zum Herstellen des Faltaktors 1 gemäß Fig. 3 wird als nächster Faltschritt der Elektrodenstreifen 2 von in der Zeichnungsebene links oben nach rechts unten gefaltet und der gegenüberliegende Elektrodenstreifen 12 danach oder gleichzeitig in die entgegengesetzte Richtung. Daraufhin wird der Elektrodenstreifen 3 von in der Zeichnungsebene rechts oben nach links unten umgefaltet und der gegenüberliegende Elektrodenstreifen 13 in die entgegengesetzte Richtung, so dass sich eine Stapelstruktur ergibt, in der immer die Elektrodenstreifen 2, 3 in Stapelrichtung alternierend mit den Elektrodenstreifen 12, 13 angeordnet sind.

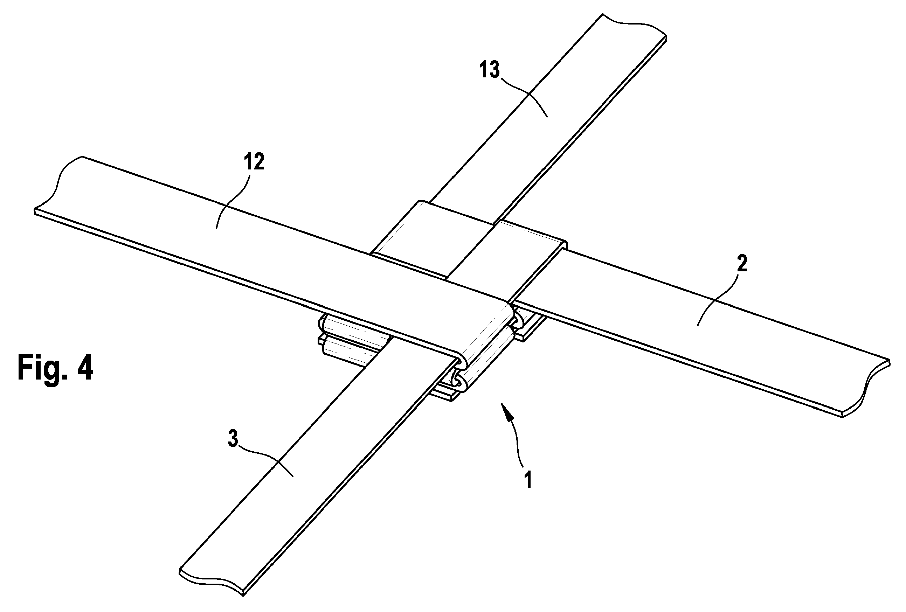

Der in Fig. 4 gezeigte Aufbau eines Faltaktors 1 unterscheidet sich von dem in Fig. 3 gezeigten Aufbau lediglich durch das Faltprinzip. Hier werden die Elektrodenstreifen 2, 3, 12, 13 in Umfangsrichtung betrachtet der Reihe nach um ihre jeweiligen Faltachsen gefaltet - die Faltabfolge rotiert also in Umfangsrichtung.

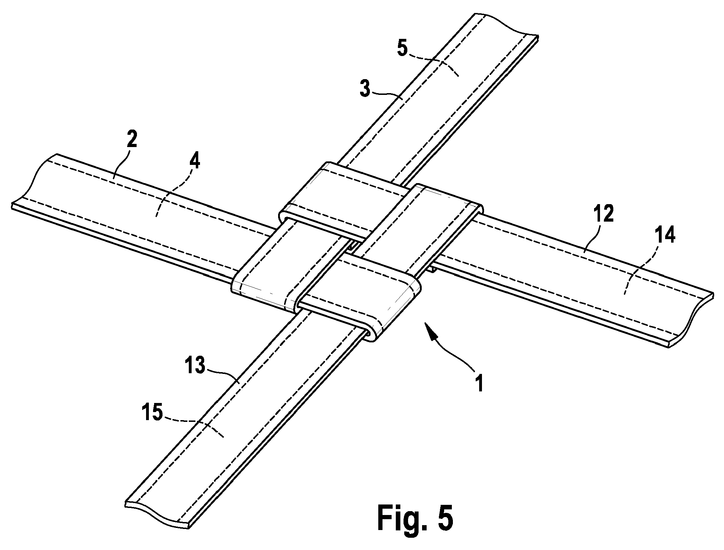

In Fig. 5 ist ein alternativer, noch nicht vollständig zu Ende gefalteter Faltaktor 1 gezeigt, der, wie die in den Fig. 3 und 4 gezeigten Faltaktoren 1 aus vier kreuzförmig angeordneten Elektrodenstreifen 2, 3, 12, 13 gebildet wird/ist. Zur Verdeutlichung der Faltfolge ist die Lage der Elektrodenschichten 4, 5, 14, 15 der einzelnen Elektrodenstreifen 2, 3, 12, 13 angedeutet, wobei auch eine andere Ausbildung und Anordnung der Elektrodenschichten 4, 5, 14, 15 realisierbar ist. Zu erkennen ist, dass die Faltfolge, wie bei dem Ausführungsbeispiel gemäß Fig. 4, in Umfangsrichtung rotiert. Im Gegensatz zu dem Ausführungsbeispiel gemäß Fig. 4 wird der jeweils zuletzt gefaltete Elektrodenstreifen 2, 3, 12, 13 nicht über einen zuvor gefalteten, quer dazu orientierten, Elektrodenstreifen gelegt, sondern unter dem drei Schritte zuvor gefalteten Elektrodenstreifen hindurchgeführt. So ist bei dem Ausführungsbeispiel gemäß Fig. 5 zu erkennen, dass der Elektrodenstreifen 2 unter dem Elektrodenstreifen 3 hindurchgeführt ist, welcher wiederum unter dem Elektrodenstreifen 12 hindurchgeführt ist, welcher wiederum unter dem Elektrodenstreifen 13 hindurchgeführt ist, welcher wiederum unter dem Elektrodenstreifen 2 hindurchgeführt ist, usw. Auf diese Weise ergibt sich eine besonders vorteilhafte, geflochtene Faltstruktur, die sich durch ihre Kompaktheit und Stabilität auszeichnet. Der Faltaktor 1 federt aufgrund seines geflochtenen Aufbaus nicht auseinander.

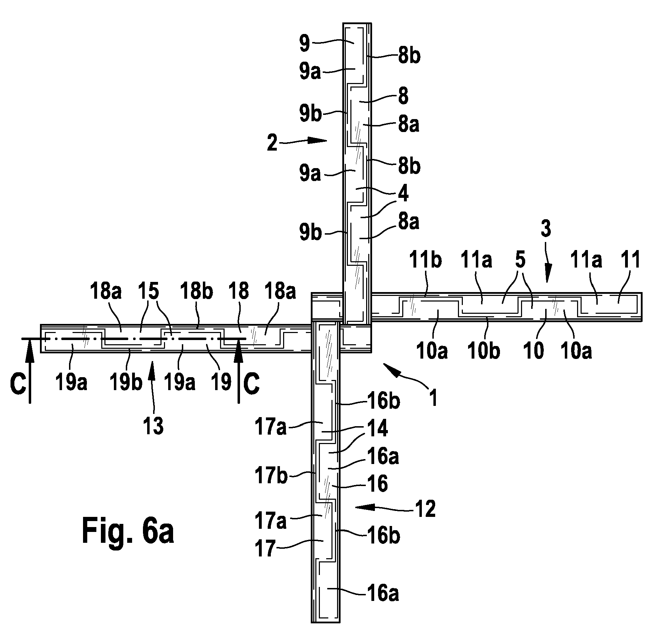

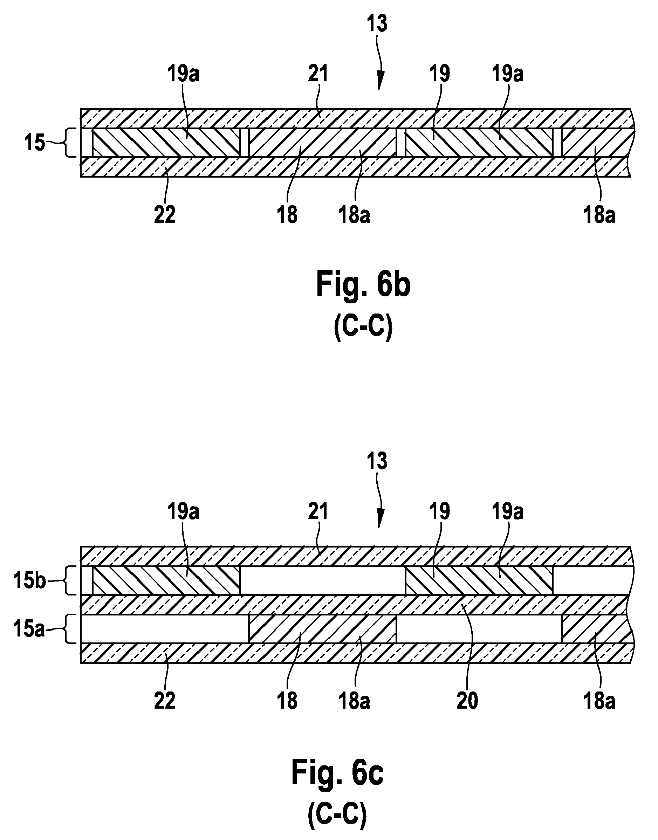

Der in Fig. 6a gezeigte, noch nicht zu Ende gefaltete Faltaktor 1 kann analog zu dem Ausführungsbeispiel gemäß den Fig. 3, 4 oder 5 gefaltet werden. Der wesentliche Unterschied des aus vier im entfalteten Zustand kreuzförmig angeordneten Elektrodenstreifen 2, 3, 12, 13 bestehenden Faltaktors 1 besteht in dem unterschiedlichen Aufbau der Elektrodenstreifen 2, 3, 12, 13. Aus Fig. 6a ist die Strukturierung der mindestens einen Elektrodenschicht 4, 5, 14, 15 der Elektrodenstreifen 2, 3, 12, 13 ersichtlich. Die Strukturierung der Elektrodenschichten 4, 5, 14, 15 ist in Fig. 6a dargestellt, da die die Elektrodenschicht/schichten 4, 5, 14, 15 einrahmenden, deformierbaren Dielektrikumsschichten transparent ausgebildet sind. Jeder Elektrodenstreifen 2, 3, 12, 13 umfasst jeweils zwei voneinander separate Elektroden 8, 9; 10, 11; 16, 17 und 18, 19. Dabei ist jede Elektrode 8, 9, 10, 11, 16, 17, 18, 19 gebildet von in Richtung der Längserstreckung des zugehörigen Elektrodenstreifens 2, 3, 12, 13 beabstandeten großflächigen Elektrodenflächen 8a, 9a, 10a, 11a, 16a, 17a, 18a, 19a, wobei die Elektrodenflächen 8a, 9a; 10a, 11a; 16a, 17a; und 18a, 19a jedes Elektrodenstreifens 2, 3, 12, 13 in Richtung der Längserstreckung des zugehörigen Elektrodenstreifens 2, 3, 12, 13 alternierend angeordnet sind. Dabei sind die großflächigen Elektrodenflächen 8a, 9a, 10a, 11a, 16a, 17a, 18a, 19a jeweils untereinander über Verbindungsstränge 8b; 9b; 10b; 11b; 16b; 17b; 18b; 19b miteinander verbunden. Im Falle der Anordnung von jeweils zwei Elektroden 8, 9; 10, 11; 16, 17; 18, 19 in jeweils einer Elektrodenschicht 4, 5, 14, 15 verlaufen die schmalen Verbindungsstränge einer ersten Elektrode eines Elektrodenstreifens immer parallel zu den Elektrodenflächen der zweiten Elektrode des jeweiligen Elektrodenstreifens und umgekehrt, wobei zu erkennen ist, dass die Quererstreckung der Verbindungsstränge einer ersten Elektrode wesentlich geringer ist als die Quererstreckung der jeweils in Querrichtung benachbarten Elektrodenflächen der zweiten Elektrode. Eine derartige Ausführungsvariante ergibt sich aus der Schnittdarstellung gemäß Fig. 6b, aus der ein dreischichtiger Elektrodenstreifenaufbau beispielhaft am Elektrodenstreifen 13 dargestellt ist. Zu erkennen ist die mittige, strukturierte Elektrodenschicht 15, die als zwei separate Elektroden 18, 19 ausgebildet (strukturiert) ist. Die Elektrodenschicht 15 ist zwischen zwei deformierbaren Dielektrikumsschichten 21, 22 aufgenommen. Die Ausführungsform gemäß Fig. 6a hat den Vorteil, dass jeder Quadrant separat ansteuerbar ist.

Es ist auch das Ausführungsbeispiel gemäß Fig. 2a mit dem aus Fig. 6a ersichtlichen Elektrodenstreifenaufbau realisierbar.

Gemäß einer in Fig. 6c gezeigten, alternativen Ausführungsvariante ist ein Fünfschichtaufbau der Elektrodenstreifen vorgesehen, bei dem die beiden Elektroden 18, 19 in voneinander beabstandeten Elektrodenschichten 15a, 15b angeordnet sind, wobei die Elektrodenschichten 15a, 15b des Elektrodenstreifens 13 durch eine deformierbare Dielektrikumsschicht 20 voneinander getrennt sind, und wobei, wie bei dem Ausführungsbeispiel gemäß Fig. 6b, die Schichtanordnung an beiden Flachseiten durch jeweils eine deformierbare Dielektrikumsschicht 21, 22 abgeschlossen ist.

Der Vorteil der in Fig. 6c gezeigten Ausführungsvariante besteht darin, dass die Elektrodenflächen 8a, 9a; 10a, 11a; 16a, 17a; 18a, 19a jeder Elektrode 8, 9, 10, 11, 16, 17, 18, 19 breiter ausgeführt werden können als bei dem Ausführungsbeispiel gemäß Fig. 6b, da kein Platz für die Verbindungsstränge der jeweils anderen Elektroden 8, 9, 10, 11, 16, 17, 18, 19 des entsprechenden Elektrodenstreifens vorgehalten werden müssen.

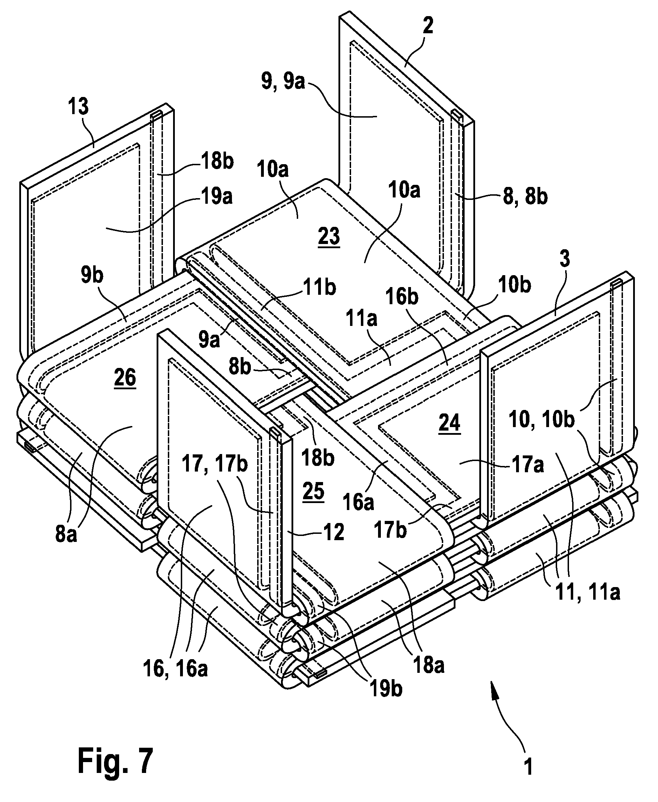

In Fig. 7 ist ein nahezu fertig gestellter Vielschichtaktor 1 gezeigt, dessen Elektrodenstreifen, wie aus den Fig. 6a und 6b ersichtlich, aufgebaut sind. Zu erkennen ist, dass vier separate Teilaktoren 23, 24, 25, 26 separat voneinander ansteuerbar sind.

Alternativ ist eine Ausführungsform realisierbar, bei der zwei sich nicht kreuzende Elektrodenstreifen nur jeweils eine durchgehende Elektrodenschicht aufweisen, also analog zu dem in Fig. 1 gezeigten Elektrodenstreifen aufgebaut sind. Hierdurch reduziert sich die Anzahl der unabhängigen Elektroden von acht auf sechs. Dennoch können sämtliche Quadranten (Teilaktoren) weiterhin separat angesteuert werden

Die in den Figuren gezeigten, zuvor anhand von Aktoren beschriebenen, Faltprinzipien sind 1:1 zur Herstellung entsprechender Faltsensoren umsetzbar, wobei diese mit einer geeigneten Auswerteeinheit versehen werden müssen, die eine Verstellbewegung, beispielsweise auf Basis von Kapazitätsmessungen, detektiert.

## Patentansprüche

1. Faltaktor oder Faltsensor, mit einer Vielzahl nebeneinander angeordneter Elektrodenabschnitte und mit zwischen zwei benachbarten Elektrodenabschnitten angeordnetem deformierbarem, insbesondere elektroaktivem, Dielektrikum, wobei der Faltaktor (1) bzw. Faltsensor durch Ineinanderfalten von mindestens zwei Elektrodenstreifen (2, 3, 12, 13) gebildet ist,
**dadurch gekennzeichnet, dass** der Faltaktor (1) bzw. Faltsensor durch das Ineinanderfalten der mindestens zwei Elektrodenstreifen (2, 3, 12, 13) einen ineinander verschachtelten Faltaktoraufbau bzw. Faltsensoraufbau aufweist, und
dass mindestens einer der Elektrodenstreifen (2, 3, 12, 13) mindestens eine Elektrodenschicht (4, 5, 14, 15, 15a, 15b) und mindestens eine deformierbare Dielektrikumsschicht (6, 7, 20, 21, 22) umfasst.

2. Faltaktor oder Faltsensor nach Anspruch 1,
**dadurch gekennzeichnet,**
**dass** mindestens zwei der Elektrodenstreifen (2, 3, 12, 13) im abgewickelten Zustand rechtwinklig zueinander angeordnet sind.

3. Faltaktor oder Faltsensor nach einem der vorhergehenden Ansprüche,
**dadurch gekennzeichnet,**
**dass** der Faltaktor (1) bzw. Faltsensor aus mindestens vier Elektrodenstreifen (2, 3, 12, 13) gefaltet ist, die abgewickelt rechtwinklig zueinander angeordnet sind.

4. Faltaktor oder Faltsensor nach einem der vorhergehenden Ansprüche,
**dadurch gekennzeichnet,**
**dass** der Faltaktor (1) bzw. Faltsensor als n * m Matrix, vorzugsweise umfassend n * m Aktorabschnitte ausgebildet ist.

5. Faltaktor oder Faltsensor nach einem der vorhergehenden Ansprüche,
**dadurch gekennzeichnet,**
**dass** die Elektrodenstreifen (2, 3, 12, 13) durch abwechselndes Umlegen und übereinander Positionieren gefaltet sind.

6. Faltaktor oder Faltsensor nach einem der vorhergehenden Ansprüche,
**dadurch gekennzeichnet,**
**dass** die Elektrodenstreifen (2, 3, 12, 13), zumindest zum Teil, verwoben sind, derart, dass mindestens ein Elektrodenstreifen (2, 3, 12, 13) unter einem zuvor gefalteten Elektrodenstreifen (2, 3, 12, 13) hindurch geführt ist.

7. Faltaktor oder Faltsensor nach einem der vorhergehenden Ansprüche,
**dadurch gekennzeichnet,**
**dass** zumindest eine Elektrodenschicht (4, 5, 14, 15, 15a, 15b) zumindest eines der Elektrodenstreifen (2, 3, 12, 13) unstrukturiert ist.

8. Faltaktor oder Faltsensor nach einem der vorhergehenden Ansprüche,
**dadurch gekennzeichnet,**
**dass** zumindest eine Elektrodenschicht (4, 5, 14, 15, 15a, 15b) zumindest eines der Elektrodenstreifen (2, 3, 12, 13) als mindestens zwei voneinander separate Elektroden (8, 9, 10, 1, 16, 17, 18, 19) strukturiert ist.

9. Faltaktor oder Faltsensor nach Anspruch 8,
**dadurch gekennzeichnet,**
**dass** die Elektroden (8, 9, 10, 11, 16, 17, 18, 19) des Elektrodenstreifens (2, 3, 12, 13) im abgewickelten Zustand als elektrisch voneinander isolierte, parallele Bahnen ausgebildet sind.

10. Faltaktor oder Faltsensor nach Anspruch 8,
**dadurch gekennzeichnet,**
**dass** die Elektrodenschichten (4, 5, 14, 15, 15a, 15b) jeweils alternierend angeordnete Elektrodenflächen (8a, 9a, 10a, 11a, 16a, 17a, 18a, 19a,) sowie die Elektrodenflächen (8a, 9a, 10a, 11a, 16a, 17a, 18a,_19a) verbindende Verbindungsstränge (8b, 9b, 10b, 11b, 16b, 17b, 18b, 19b) umfassen.

11. Faltaktor oder Faltsensor nach einem der vorhergehenden Ansprüche,
**dadurch gekennzeichnet, dass** in mindestens einem der Elektrodenstreifen (2, 3, 12, 13) mindestens zwei voneinander separate Elektroden (8, 9, 10, 11, 16, 17, 18, 19) realisiert sind, wobei die Elektroden (8, 9, 10, 11, 16, 17, 18, 19)_entweder in einer gemeinsamen Elektrodenschicht (4, 5, 14, 15, 15a, 15b) oder in mindestens zwei, insbesondere durch jeweils mindestens eine Dielektrikumsschicht (6, 7, 20, 21, 22) voneinander getrennten, Elektrodenschichten (4, 5, 14, 15, 15a, 15b) realisiert sind.

12. Faltaktor oder Faltsensor nach einem der vorhergehenden Ansprüche,
**dadurch gekennzeichnet,**
**dass** zumindest einer der Elektrodenstreifen (2, 3, 12, 13) eine Schichtanordnung, umfassend eine zwischen zwei Dielektrikumsschichten (6, 7, 20, 21, 22) aufgenommene Elektrodenschicht (4, 5, 14, 15, 15a, 15b), umfasst.

13. Faltaktor oder Faltsensor nach Anspruch 12,
**dadurch gekennzeichnet,**
**dass** der Elektrodenstreifen (2, 3, 12, 13) aus der Schichtanordnung besteht.

14. Faltaktor oder Faltsensor nach Anspruch 12,
**dadurch gekennzeichnet,**
**dass** an die Schichtanordnung mindestens eine weitere Elektrodenschicht (4, 5, 14, 15, 15a, 15b) und/oder mindestens eine weitere Dielektrikumsschicht (6, 7, 20, 21, 22) angrenzen/angrenzt.

15. Verfahren zum Herstellen eines Faltaktors (1) oder eines Faltsensors, insbesondere nach einem der vorhergehenden Ansprüche, mit einer Vielzahl nebeneinander angeordneter Elektrodenabschnitte und mit zwischen zwei benachbarten Elektrodenabschnitten angeordnetem deformierbarem, insbesondere elektroaktivem, Dielektrikum, wobei
mindestens zwei Elektrodenstreifen (2, 3, 12, 13) ineinander gefaltet werden, **dadurch gekennzeichnet, dass** der Faltaktor (1) bzw. Faltsensor durch das Ineinanderfalten der mindestens zwei Elektrodenstreifen (2, 3, 12, 13) einen ineinander verschachtelten Faltaktoraufbau bzw. Faltsensoraufbau aufweist, und
dass mindestens einer der Elektrodenstreifen (2, 3, 12, 13) mindestens eine Elektrodenschicht (4, 5, 14, 15, 15a, 15b) und mindestens eine deformierbar Dielektrikumsschicht (6, 7, 20, 21, 22) umfasst.

16. Verfahren nach Anspruch 15,
**dadurch gekennzeichnet,**
**dass** mindestens zwei der Elektrodenstreifen (2, 3, 12, 13) vor dem Falten rechtwinklig zueinander angeordnet werden.

## Claims

1. Fold actuator or fold sensor having a large number of electrode sections which are arranged next to one another, and having a deformable, in particular electroactive, dielectric which is arranged between two adjacent electrode sections, wherein the fold actuator (1) or fold sensor is formed by folding at least two electrode strips (2, 3, 12, 13) one into the other, **characterized in that** the fold actuator (1) or fold sensor has an interleaved fold actuator structure or fold sensor structure owing to the at least two electrode strips (2, 3, 12, 13) being folded one into the other, and **in that** at least one of the electrode strips (2, 3, 12, 13) comprises at least one electrode layer (4, 5, 14, 15, 15a, 15b) and at least one deformable dielectric layer (6, 7, 20, 21, 22).

2. Fold actuator or fold sensor according to Claim 1, **characterized in that** at least two of the electrode strips (2, 3, 12, 13) are arranged at a right angle in relation to one another in the unwound state.

3. Fold actuator or fold sensor according to either of the preceding claims, **characterized in that** the fold actuator (1) or fold sensor is folded from at least four electrode strips (2, 3, 12, 13) which are arranged at a right angle in relation to one another in unwound form.

4. Fold actuator or fold sensor according to one of the preceding claims, **characterized in that** the fold actuator (1) or fold sensor is in the form of an n*m matrix, preferably comprising n*m actuator sections.

5. Fold actuator or fold sensor according to one of the preceding claims, **characterized in that** the electrode strips (2, 3, 12, 13) are folded by alternately folding over the said electrode strips and positioning them one above the other.

6. Fold actuator or fold sensor according to one of the preceding claims, **characterized in that** the electrode strips (2, 3, 12, 13) are at least partially interwoven in such a way that at least one electrode strip (2, 3, 12, 13) is passed through beneath a previously folded electrode strip (2, 3, 12, 13).

7. Fold actuator or fold sensor according to one of the preceding claims, **characterized in that** at least one electrode layer (4, 5, 14, 15, 15a, 15b) of at least one of the electrode strips (2, 3, 12, 13) is unstructured.

8. Fold actuator or fold sensor according to one of the preceding claims, **characterized in that** at least one electrode layer (4, 5, 14, 15, 15a, 15b) of at least one of the electrode strips (2, 3, 12, 13) is structured as at least two electrodes (8, 9, 10, 11, 16, 17, 18, 19) which are separate from one another.

9. Fold actuator or fold sensor according to Claim 8, **characterized in that** the electrodes (8, 9, 10, 11, 16, 17, 18, 19) of the electrode strip (2, 3, 12, 13) are in the form of parallel tracks which are electrically insulated from one another in the unwound state.

10. Fold actuator or fold sensor according to Claim 8, **characterized in that** the electrode layers (4, 5, 14, 15, 15a, 15b) each comprise alternately arranged electrode areas (8a, 9a, 10a, 11a, 16a, 17a, 18a, 19a) and connection sections (8b, 9b, 10b, 11b, 16b, 17b, 18b, 19b) which connect the electrode areas (8a, 9a, 10a, 11a, 16a, 17a, 18a, 19a).

11. Fold actuator or fold sensor according to one of the preceding claims, **characterized in that** at least two electrodes (8, 9, 10, 11, 16, 17, 18, 19) which are separate from one another are realized in at least one of the electrode strips (2, 3, 12, 13), wherein the electrodes (8, 9, 10, 11, 16, 17, 18, 19) are realized either in a common electrode layer (4, 5, 14, 15, 15a, 15b) or in at least two electrode layers (4, 5, 14, 15, 15a, 15b), in particular which are separated from one another by in each case at least one dielectric layer (6, 7, 20, 21, 22).

12. Fold actuator or fold sensor according to one of the preceding claims, **characterized in that** at least one of the electrode strips (2, 3, 12, 13) comprises a layer arrangement comprising an electrode layer (4, 5, 14, 15, 15a, 15b) which is accommodated between two dielectric layers (6, 7, 20, 21, 22).

13. Fold actuator or fold sensor according to Claim 12, **characterized in that** the electrode strips (2, 3, 12, 13) consist of the layer arrangement.

14. Fold actuator or fold sensor according to Claim 12, **characterized in that** at least one further electrode layer (4, 5, 14, 15, 15a, 15b) and/or at least one further dielectric layer (6, 7, 20, 21, 22) adjoin/adjoins the layer arrangement.

15. Method for producing a fold actuator (1) or a fold sensor, in particular according to one of the preceding claims, having a large number of electrode sections which are arranged next to one another, and having a deformable, in particular electroactive, dielectric which is arranged between two adjacent electrode sections, wherein at least two electrode strips (2, 3, 12, 13) are folded one into the other, **characterized in that** the fold actuator (1) or fold sensor has an interleaved fold actuator structure or fold sensor structure owing to the at least two electrode strips (2, 3, 12, 13) being folded one into the other, and **in that** at least one of the electrode strips (2, 3, 12, 13) comprises at least one electrode layer (4, 5, 14, 15, 15a, 15b) and at least one deformable dielectric layer (6, 7, 20, 21, 22).

16. Method according to Claim 15, **characterized in that** at least two of the electrode strips (2, 3, 12, 13) are arranged at a right angle in relation to one another before the folding operation.

## Revendications

1. Actionneur de pliage ou capteur de pliage, comportant une pluralité de sections d'électrode et comportant un diélectrique déformable, notamment électro-actif, disposé entre deux sections d'électrode voisines, dans lequel l'actionneur de pliage (1) ou le capteur de pliage est formé en repliant l'une à l'intérieur de l'autre au moins deux bandes d'électrodes (2, 3, 12, 13),
**caractérisé en ce que** l'actionneur de pliage (1) ou le capteur de pliage comprend une structure d'actionneur de pliage ou une structure de capteur de pliage imbriquées l'une dans l'autre au moyen du pliage l'une dans l'autre des au moins deux bandes d'électrodes (2, 3, 12, 13), et
**en ce qu'**au moins l'une des bandes d'électrodes (2, 3, 12, 13) comprend au moins une couche d'électrode (4, 5, 14, 15, 15a, 15b) et au moins une couche de diélectrique déformable (6, 7, 20, 21, 22).

2. Actionneur de pliage ou capteur de pliage selon la revendication 1,
**caractérisé en ce qu'**au moins deux des bandes d'électrodes (2, 3, 12, 13) sont disposées perpendiculairement l'une à l'autre à l'état déplié.

3. Actionneur de pliage ou capteur de pliage selon l'une quelconque des revendications précédentes,
**caractérisé en ce que** l'actionneur de pliage (1) ou le capteur de pliage est plié à partir d'au moins quatre bandes d'électrodes (2, 3, 12, 13) qui sont disposées de manière dépliée perpendiculairement l'une par rapport à l'autre.

4. Actionneur de pliage ou capteur de pliage selon l'une quelconque des revendications précédentes,
**caractérisé en ce que** l'actionneur de pliage (1) ou le capteur de pliage est réalisé sous la forme d'une matrice n*m, comprenant de préférence n*m sections d'actionneur.

5. Actionneur de pliage ou capteur de pliage selon l'une quelconque des revendications précédentes,
**caractérisé en ce que** les bandes d'électrodes (2, 3, 12, 13) sont repliées en étant rabattues de manière alternée et en étant positionnées les unes sur les autres.

6. Actionneur de pliage ou capteur de pliage selon l'une quelconque des revendications précédentes,
**caractérisé en ce que** les bandes d'électrodes (2, 3, 12, 13) sont au moins partiellement entrelacées de manière à ce qu'au moins une bande d'électrode (2, 3, 12, 13) soit guidée en dessous d'une bande d'électrode (2, 3, 12, 13) ayant été précédemment pliée.

7. Actionneur de pliage ou capteur de pliage selon l'une quelconque des revendications précédentes,
**caractérisé en ce qu'**au moins une couche d'électrode (4, 5, 14, 15, 15a, 15b) d'au moins l'une des bandes d'électrodes (2, 3, 12, 13) n'est pas structurée.

8. Actionneur de pliage ou capteur de pliage selon l'une quelconque des revendications précédentes,
**caractérisé en ce qu'**au moins une couche d'électrode (4, 5, 14, 15, 15a, 15b) d'au moins l'une des bandes d'électrodes (2, 3, 12, 13) est structurée sous la forme d'au moins deux électrodes (8, 9, 10, 11, 16, 17, 18, 19) séparées l'une de l'autre.

9. Actionneur de pliage ou capteur de pliage selon la revendication 8,
**caractérisé en ce que** les électrodes (8, 9, 10, 11, 16, 17, 18, 19) de la bande d'électrode (2, 3, 12, 13) sont réalisées, à l'état déplié, sous la forme de pistes parallèles électriquement isolées les unes des autres.

10. Actionneur de pliage ou capteur de pliage selon la revendication 8,
**caractérisé en ce que** les couches d'électrodes (4, 5, 14, 15, 15a, 15b) comprennent respectivement des surfaces d'électrodes (8a, 9a, 10a, 11a, 16a, 17a, 18a, 19a) disposées de manière alternée ainsi que des cordons de connexion (8b, 9b, 10b, 11b, 16b, 17b, 18b, 19b) connectant les surfaces d'électrodes (8a, 9a, 10a, 11a, 16a, 17a, 18a, 19a).

11. Actionneur de pliage ou capteur de pliage selon l'une quelconque des revendications précédentes,
**caractérisé en ce qu'**au moins deux électrodes (8, 9, 10, 11, 16, 17, 18, 19) séparées l'une de l'autre sont réalisées dans au moins l'une des bandes d'électrodes (2, 3, 12, 13), dans lequel les électrodes (8, 9, 10, 11, 16, 17, 18, 19) sont réalisées soit dans une couche d'électrode commune (4, 5, 14, 15, 15a, 15b), soit dans au moins deux couches d'électrodes (4, 5, 14, 15, 15a, 15b) respectivement séparées l'une de l'autre par au moins une couche de diélectrique (6, 7, 20, 21, 22).

12. Actionneur de pliage ou capteur de pliage selon l'une quelconque des revendications précédentes,
**caractérisé en ce qu'**au moins l'une des bandes d'électrodes (2, 3, 12, 13) comprend un agencement de couches comprenant une couche d'électrode (4, 5, 14, 15, 15a, 15b) reçue entre deux couches de diélectrique (6, 7, 20, 21, 22).

13. Actionneur de pliage ou capteur de pliage selon la revendication 12,
**caractérisé en ce que** la bande d'électrode (2, 3, 12, 13) est constituée d'un agencement de couches.

14. Actionneur de pliage ou capteur de pliage selon la revendication 12,
**caractérisé en ce qu'**une autre couche d'électrode (4, 5, 14, 15, 15a, 15b) et/ou au moins une autre couche de diélectrique (6, 7, 20, 21, 22) est/sont adjacente(s) à l'agencement de couches.

15. Procédé de réalisation d'un actionneur de pliage (1) ou d'un capteur de pliage, notamment selon l'une quelconque des revendications précédentes, comportant une pluralité de sections d'électrodes disposées côte à côte et comportant un diélectrique déformable, notamment électro-actif, disposé entre deux sections d'électrodes voisines, dans lequel
au moins deux bandes d'électrodes (2, 3, 12, 13) sont repliées l'une dans l'autre, **caractérisé en ce que** l'actionneur de pliage (1) ou le capteur de pliage comprend une structure d'actionneur de pliage ou une structure de capteur de pliage imbriquées l'une dans l'autre au moyen du pliage l'une dans l'autre des au moins deux bandes d'électrodes (2, 3, 12, 13), et
**en ce qu'**au moins l'une des bandes d'électrodes (2, 3, 12, 13) comprend au moins une couche d'électrode (4, 5, 14, 15, 15a, 15b) et au moins une couche de diélectrique déformable (6, 7, 20, 21, 22).

16. Procédé selon la revendication 15,
**caractérisé en ce qu'**au moins deux bandes d'électrodes (2, 3, 12, 13) sont disposées perpendiculairement l'une à l'autre avant le pliage.
